Europäisches Patentamt

European Patent Office

Office européen des brevets

(11) Veröffentlichungsnummer: **0 026 538**
**B2**

(12) **NEUE EUROPÄISCHE PATENTSCHRIFT**

(45) Veröffentlichungstag der neuen Patentschrift:
**12.07.89**

(21) Anmeldenummer: **80200698.7**

(22) Anmeldetag: **25.09.80**

(51) Int. Cl.⁴: **G 03 F 7/12**

(54) **Vorrichtung zur Beschichtung eines Drucksiebes.**

(30) Priorität: **02.10.79 CH 8879/79**

(43) Veröffentlichungstag der Anmeldung:
**08.04.81 Patentblatt 81/14**

(45) Bekanntmachung des Hinweises auf die Patenterteilung:
**04.05.83 Patentblatt 83/18**

(45) Bekanntmachung des Hinweises auf die Entscheidung
über den Einspruch:
**12.07.89 Patentblatt 89/28**

(84) Benannte Vertragsstaaten:
**AT BE DE FR GB IT NL SE**

(56) Entgegenhaltungen:
**CH-A-310 479**
**DE-A-2 504 701**
**DE-A-2 606 328**
**DE-A-2 750 690**
**DE-A-2 810 556**
**DE-B-2 559 350**
**DE-C-711 758**
**FR-A-2 345 223**
**US-A-1 676 363**
**US-A-3 889 629**

**FORM UND TECHNIK, Band 22, Juli 1971, Stuttgart**
**ERICH SCHMIDT: "Die Formherstellung im**
**Siebdruck", Seiten 415, 416, 418**
**ING. W. CERMAK "Lehrbuch für den Siebdrucker",**
**5. Auflage, 1967 VEB Fachbuchverlag Leipzig,**
**Seiten 106-109**

(73) Patentinhaber: **Harlacher AG, Gartenstrasse 7, CH-8902 Urdorf/ZH (CH)**

(72) Erfinder: **Gasser, Rudolf, Dörnliacker 11, CH- 8952 Schlieren (Zürich) (CH)**

(74) Vertreter: **Bovard, Fritz Albert, Bovard & Cie Patentanwälte VSP Optingenstrasse 16, CH- 3000 Bern 25 (CH)**

LIBER, STOCKHOLM 1989

**Beschreibung**

Die vorliegende Erfindung bezieht sich auf eine Vorrichtung zum zweiseitigen Beschichten eines ebenen Drucksiebes mit einer Fotoemulsion.

Bei einem bekannten Verfahren gemäss der CH-A-560 407 wird ein ringförmiger, mit flüssigem Material gefüllter Behälter, der auf der Unterseite durch eine Manschette abgeschlossen ist, von oben nach unten entlang der zu beschichtenden zylindrischen Schablone geführt. In der DE-A-2 733 216 ist ein ähnliches Verfahren zur Beschichtung eines Siebzylinders beschrieben. Es ist ebenfalls bekannt, ebene Siebdruckschablonen mit einer Rakel von Hand einseitig zu beschichten.

Die in den oben erwähnten Druckschriften beschriebenen Verfahren eignen sich nur zum Beschichten von zylindrischen Druckschablonen. Im weiteren erfolgt bei den bekannten Verfahren der Auftrag der lichtempfindlichen Emulsion nur auf der Aussenseite. Bei der Beschichtung von Hand ist der Auftrag sehr unregelmässig, im weiteren erfordert dieses Verfahren einen zu grossen Arbeitsaufwand. Bei der einseitigen Beschichtung besteht die Gefahr, dass die Fotoemulsion durch das Sieb hindurchtritt und die Netzstruktur beim späteren Druckvorgang hervortritt. Im weiteren ist aus der US-A-1 676 363 ein Verfahren zur Imprägnierung von Gewebe mit flüssigem Material bekannt, bei dem mindestens eine sich horizontal erstreckende, das flüssige Material enthaltende Rakel verwendet wird und das Gewebe zum Auftragen des flüssigen Materials in vertikaler Richtung bewegt wird, wobei die Bewegung automatisch erfolgt.

Aus der DE-C-11 758 ist eine Vorrichtung zum gleichzeitigen beidseitigen Bedrucken von Stoffbahnen mittels Schablonen vorbekannt. In die Schablonen werden Streichrakeln dermassen eingelegt, dass die entsprechenden Streichkanten einander genau gegenüberliegen. Diese Vorrichtung eignet sich nicht zum gleichmässigen und reproduzierbaren zweiseitigen Beschichten eines ebenen Drucksiebes.

Aus der DE-A-2 750 690 ist eine Vorrichtung zum Herstellen einer Schablone für Siebdruckformen vorbekannt. Bei dieser Vorrichtung ist das zu beschichtende Gewebe horizontal angeordnet, wobei eine Beschichtungsrakel und eine dieser vorlaufende Gegenrakel vorgesehen sind. Mit dieser Vorrichtung ist keine zweiseitige Beschichtung möglich.

Aus der CH-A-310 479 ist eine Vorrichtung zum Bedrucken von Warenbahnen durch eine Schablone hindurch vorbekannt. Eine solche Vorrichtung eignet sich nicht zum gleichmässigen und reproduzierbaren Auftragen einer Fotoemulsion auf Drucksiebe.

Aus der DE-C-2 504 701 ist eine Vorrichtung zum zweiseitigen Beschichten einer von unten nach oben bewegten Bahn mit zwei horizontalen, vertikal gegeneinander versetzten Beschichtungsrakeln und Antriebsmitteln zur Ausführung einer vertikalen Bewegung der Bahn zum Auftragen des in die Rakeln einfüllbaren Materials bekannt.

Es ist Aufgabe der vorliegenden Erfindung, eine Vorrichtung zu schaffen, mit welcher ebene Drucksiebe mit einer Fotoemulsion zweiseitig beschichtet werden können.

Gemäss einer weiteren Aufgabe der Erfindung soll der Auftrag der Fotoemulsion auch bei hoher Auftragsgeschwindigkeit gleichmässig und reproduzierbar erfolgen.

Gemäss einer weiteren Aufgabe der Erfindung soll die Dicke der aufgetragenen Fotoemulsionsschicht variiert werden können.

Weiterhin soll auch ein dicker Auftrag gleichmässig und reproduzierbar erfolgen können.

Gemäss einer weiteren Aufgabenstellung soll vermieden werden, dass an den Stellen, wo die Rakelkanten von der Geradlinigkeit abweichen, Fotoemulsion in Streifen dem Gewebe entlang nach unten läuft und eine Ungleichmässigkeit des aufgetragenen Belages bewirkt.

Dies wird erfindungsgemäss erreicht durch die kennzeichnenden Merkmale des Patentanspruches 1.

Besondere Ausführungsformen der Erfindung ergeben sich aus den Merkmalen der abhängigen Ansprüche.

Im folgenden wird ein Ausführungsbeispiel der Erfindung anhand der Zeichnung näher beschrieben. Es zeigen:

Fig. 1 eine Ansicht einer Beschichtungsvorrichtung mit dem zu beschichtenden Drucksieb,

Fig. 2 die Verschiebe- und Verkippvorrichtung mit den Rakeln in Ruhestellung,

Fig. 3 die Verschiebe- und Verkippvorrichtung mit den Rakeln in Arbeitsstellung,

Fig. 4 einen Schnitt gemäss Linie A - A der Fig. 3,

Fig. 5 ein Blockschaltbild der Vorrichtung mit der Steuerung.

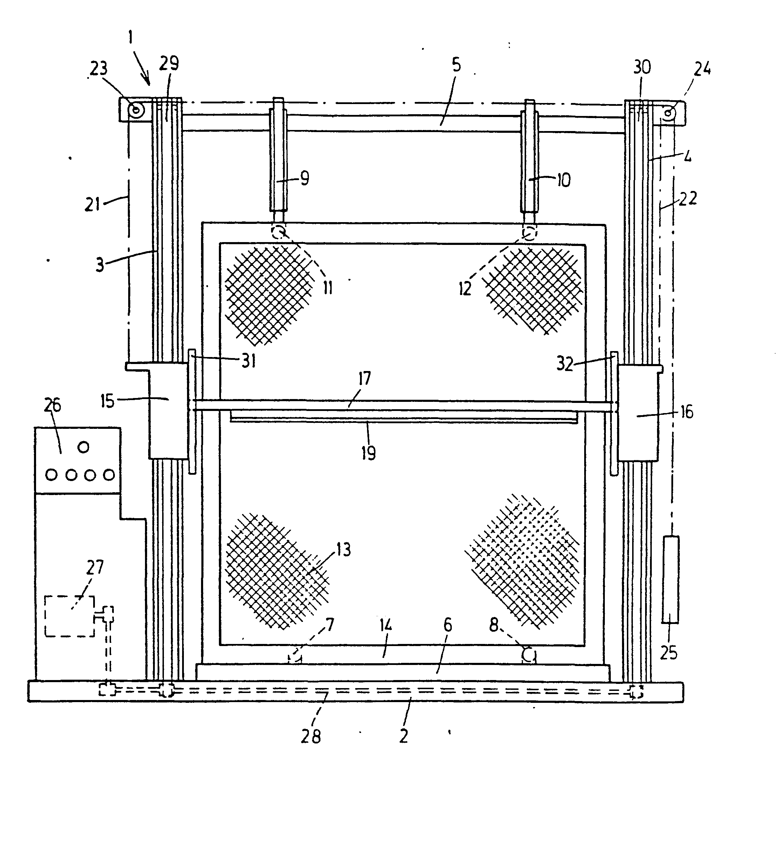

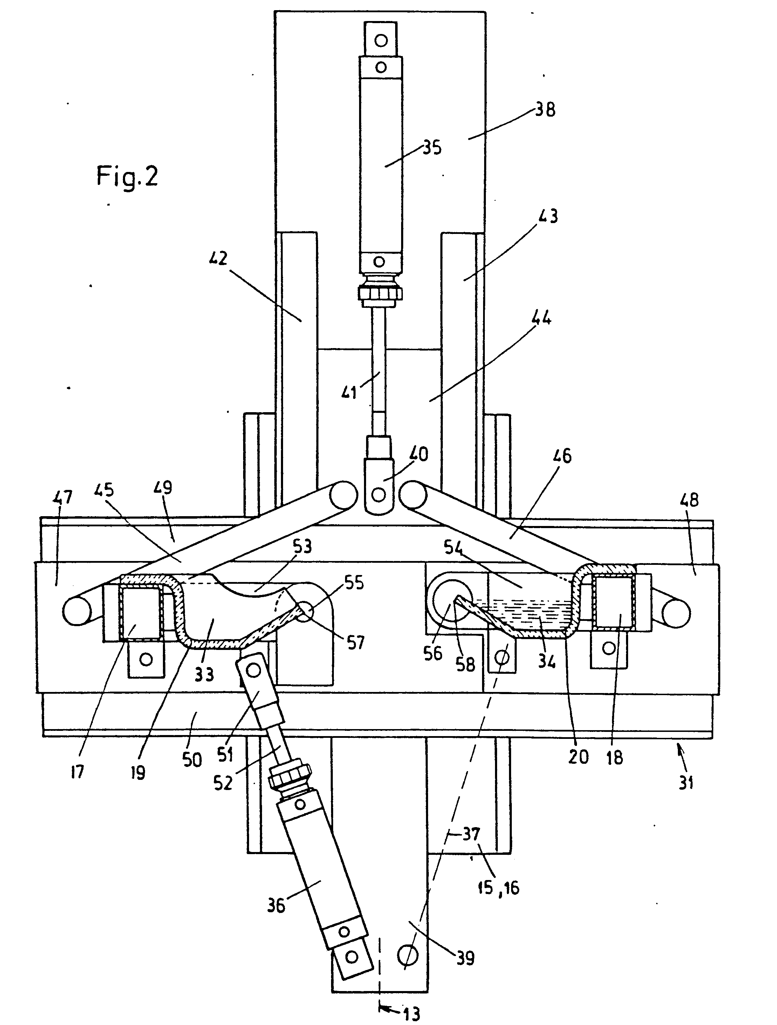

Gemäss Fig. 1 besteht ein Rahmen 1 im wesentlichen aus dem am Boden befindlichen Sockel 2, den vertikalen Pfosten 3, 4 und einem horizontalen oberen Balken 5. Auf einer Schiene 6 auf dem Sockel 2 sind zwei Magnethalter 7, 8 verstellbar angeordnet. Am Balken sind zwei in der Höhe verstellbare Stützen 9, 10, die an ihren Enden mit weiteren Magnethaltern 11, 12 versehen sind, montiert. Das Drucksieb 13 besteht aus einem Gewebe aus Polyester, Nylon, Chromstahl oder Seide und ist in einem Rahmen 14 eingespannt, der an den vier Magnethaltern 7, 8, 11, 12 befestigt wird. Der Rahmen 14 mit dem Drucksieb 13 könnte auch mit einer mechanischen Vorrichtung gehaltert werden. An den Pfosten 3, 4 ist je ein nach oben und unten verschiebbarer Wagen 15, 16 mit Rollen geführt. Zwischen den Wagen 15, 16 sind auf beiden Seiten des Gewebes 13 Querstangen 17, 18 (Fig. 2) an den Wagen befestigt, die je eine Rakel 19, 20 (Fig. 2) tragen. An jedem Wagen 15, 16 ist ein Drahtseil 21, 22 befestigt. Diese Drahtseile sind über Rollen 23, 24 zu einem Gegengewicht 25 geführt und mit diesem verbunden. In einem Steuerpult 26 ist ein Elektromotor 27 zum vertikalen Bewegen der Rakeln 19, 20 entlang dem Gewebe 13 vorgesehen. Der Motor 27 treibt über eine Welle zwei Zahnriemen 29 und 30 aus Gummi an. Mit den Zahnriemen 29, 30 werden die Wagen 15, 16 entlang der Pfosten 3 und 4 von oben nach unten resp. von unten nach oben bewegt. Auf der Innenseite gegen den Rahmen 14 zu sind an beiden Wagen 15, 16 Verstelleinrichtungen 31, 32 zum Verkippen der Rakeln 19, 20 angeordnet.

Der Antrieb mit Zahnriemen 29, 30 aus Gummi sowie das Gegengewicht 25 gewährleisten eine erschütterungsfreie Bewegung der Rakeln 19, 20, was für einen gleichmässigen Auftrag der Fotoemulsion auf das Drucksieb 13 von grosser Wichtigkeit ist. Die Magnethalter 7, 8, 11, 12 gestatten eine schnelle und doch zuverlässige Befestigung des Rahmens 14 mit dem eingespannten Gewebe.

In Fig. 2 ist die an beiden Wagen 15, 16 angebrachte Verstelleinrichtung 31, 32 (Fig. 1) für die Rakeln dargestellt, und zwar befinden sich die Rakeln 19, 20 in Ruhestellung. In dieser Stellung kann der Rahmen 14 mit dem Gewebe 13 in der Beschichtungsvorrichtung befestigt werden. In die seitlich mit einer Abschlusswand 33 versehene Rakel wird die Fotoemulsion 34 eingefüllt, wie das durch die Niveaulinie bei der Rakel 20 rechts in der Fig. 2 dargestellt ist. Die Verkippung der Rakel von der Ruhe- in die Arbeitsstellung geschieht durch die pneumatischen Zylinder 35, 36, 37, wobei der Zylinder 37, der die gleiche Funktion ausübt wie der Zylinder 36, nur durch seine Achse dargestellt ist. Der obere vertikale Zylinder 35 ist an einer oberen Halteplatte 38 befestigt, die beiden unteren schräg angeordneten Zylinder 36 und 37 an einer unteren Platte 39. Die Halteplatten 38, 39 sind mit den Wagen 15 resp. 16 verschraubt. Das Ende 40 des Kolbens 41 des oberen Zylinders ist mit einem in Führungsschienen 42, 43 geführten Schlitten 44 verbunden. Der vertikale Schlitten 44 ist über Hebel 45, 46 mit horizontalen Schlitten 47, 48 verbunden. Die Schlitten 47, 48 werden in Führungsschienen 49, 50 geführt.

Eine Aufwärtsbewegung des Kolbens 41 bewirkt eine horizontale Verschiebung der Schlitten 47, 48 und damit der an den Querstangen 17, 18 befestigten Rakeln 19, 20 nach innen gegen das Drucksieb 13 zu. Die oberen Enden 51 der Kolben 52 der unteren Zylinder 36, 37 sind mit den Kipparmen 53, 54 verbunden. Diese Kipparme 53, 54 werden um die Drehbolzen 55, 56 verkippt. Die Enden 57, 58 der Rakeln 19, 20 liegen in den Drehachsen der Kipparme 53, 54. Die Kipparme sind über die Drehbolzen 55, 56 mit den Schlitten 47, 48 verbunden. Der rechte Schlitten 48 weist einen unteren Absatz und der linke Schlitten 47 einen oberen Absatz auf, so dass beim Heranfahren der Rakeln 19, 20 zum Drucksieb 13 die Drehbolzen 55, 56 übereinander gelangen können. An den Kipparmen 53 und 54 sind die Querstangen 17 und 18 befestigt. Die Rakeln werden an diese Querstangen geschraubt.

Die vordere Kante 58 der rechten Rakel 20 gemäss Fig. 2 liegt ca. 4 - 10 mm höher als die vordere Kante 57 der linken Rakel 19 gemäss Fig. 2. Bei der Beschichtung von Drucksieben für die Anwendung zur Färbung von Textilien liegt sie etwa 8 mm höher, bei Drucksieben zur Anwendung in der Elektronik etwa 4 mm höher.

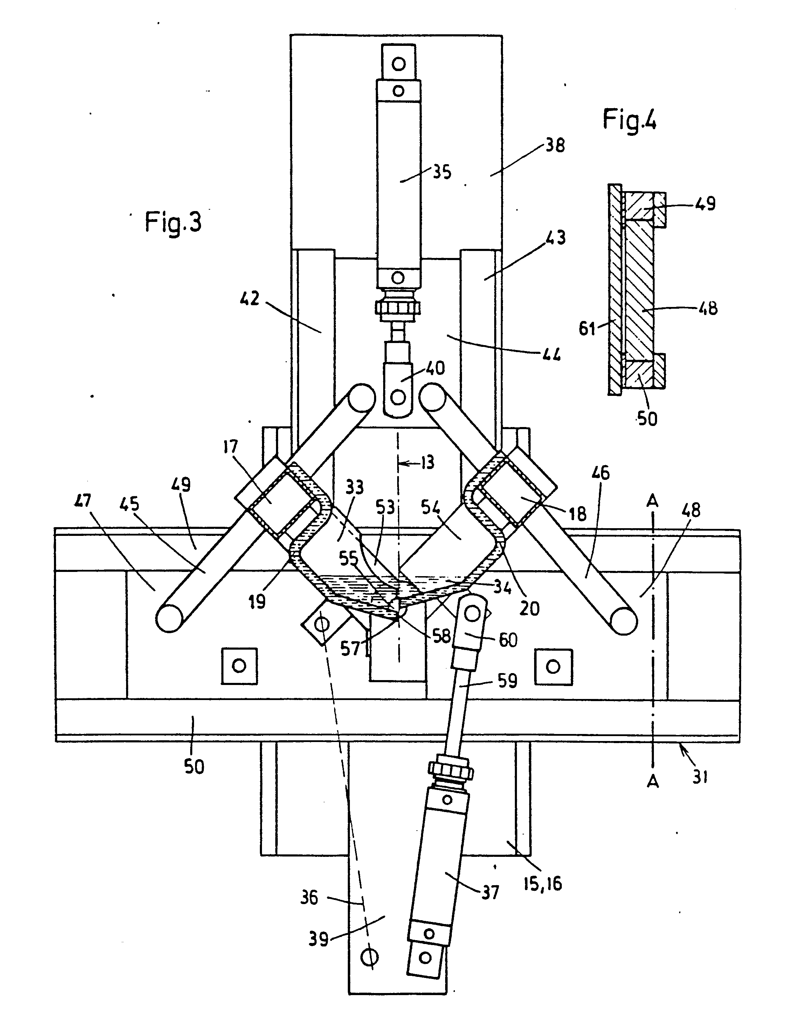

In Fig. 3 ist die Verkippvorrichtung mit den Rakeln 19, 20 in Arbeitsstellung ersichtlich. Eine Betätigung des Zylinders 35, d. h. ein Einfahren des Kolbens 41 bewirkt ein Verschieben der Schlitten 47, 48 und damit der Rakeln 19, 20, die sich noch in horizontaler Lage befinden, nach innen gegen das Gewebe 13 zu. Wenn die Rakelkanten das Gewebe 13 berühren, werden durch Betätigung der pneumatischen unteren Zylinder 36, 37, d. h. durch Ausstossen der Kolben 52, 59, die Kipparme 53, 54, die mit den Kolbenenden 51, 60 verbunden sind, um die Drehbolzen 55, 56 nach oben verschwenkt. Dabei gelangen die Rakeln 19, 20 in Arbeitsstellung. Die Emulsion fliesst zum Drucksieb 13.

Wichtig ist, dass die vorderen Kanten 57, 58 der Rakeln mit den Drehachsen der Kipparme 53, 54 identisch sind, damit die am Gewebe anliegenden Rakelkanten 57, 58 sich nicht bewegen und das Gewebe beschädigen.

Aus Fig. 4 ist ein Schnitt gemäss der Linie A - A der Fig. 3 ersichtlich. Der Schlitten 48 läuft innerhalb der mit Nuten versehenen Führungsschienen 49, 50. Die Führungsschienen 49 und 50 sind auf eine Grundplatte 61 montiert.

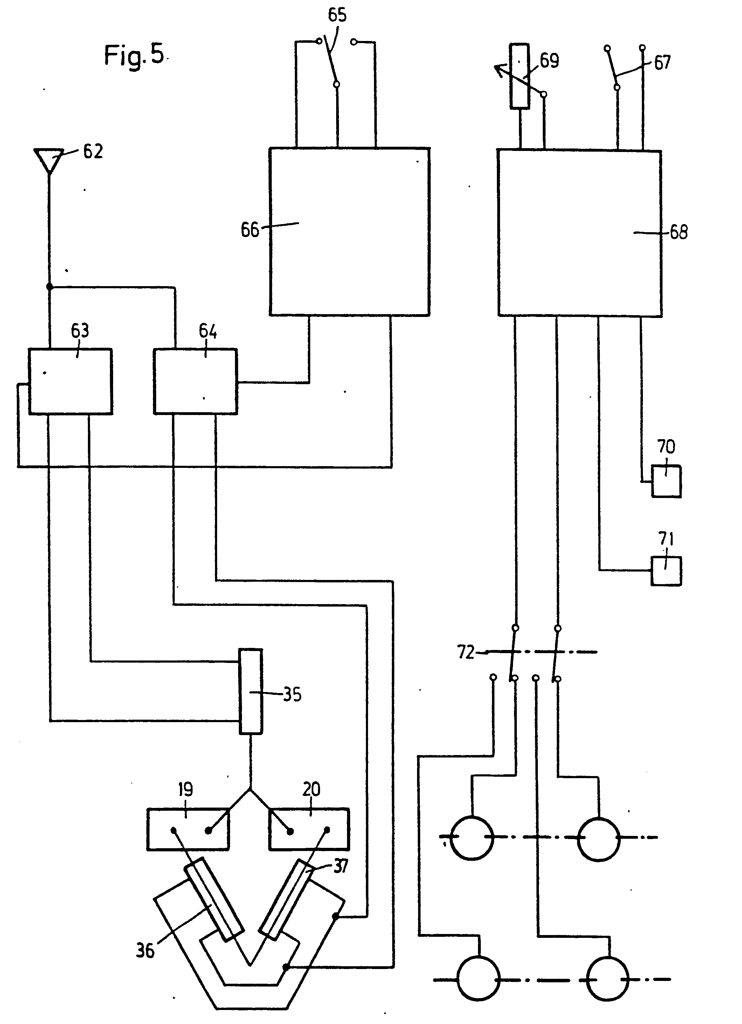

Aus Fig. 5 ist ein Blockdiagramm zur Steuerung der Flachbeschichtungsmaschine ersichtlich. Über einen Druckluftanschluss 62 wird über Magnetventile 63, 64 den drei Zylindern 35, 36 und 37 Druckluft zugeführt. Die durch die Zylinder 35, 36 und 37 gesteuerten Rakeln 19 und 20 sind schematisch dargestellt. Mit einem Schalter 65 wird die Zeitsteuerung 66 für den Zylinderablauf, d. h. für die Verschiebung der Rakeln nach innen und Verkippung nach oben, betätigt. Mit einem Schalter 67 wird das Drehzahlregelgerät 68 eingeschaltet. Die Drehzahl kann mit dem Potentiometer 69 eingestellt werden. Mit einem oberen und unteren Endschalter 70, 71 wird die obere resp. untere Endlage der Wagen 15, 16 und somit der Rakeln 19, 20 begrenzt. Mit dem Schalter 72 kann eine schnelle resp. langsame Bewegung der Wagen 15, 16 entlang der Pfosten 3, 4 eingestellt werden. Die schnelle Bewegung wird nach Beendigung der Beschichtung eingestellt, damit die Rakeln schnell in die ursprüngliche Lage zurückkehren und der Rahmen 14 mit dem Gewebe 13 1er Vorrichtung entnommen werden kann. Die Steuerung kann jedoch auch vollautomatisch erfolgen, indem z. B. je nach gewünschter Beschichtungsart ein entsprechendes Programm gewählt wird.

Im folgenden soll der Verfahrensablauf zur Bechichtung des flachen Drucksiebes erläutert werden. Der Rahmen 14 mit dem Gewebe 13 wird an den Magnethaltern 7, 8, 11, 12 befestigt. Die Rakeln werden entweder in eine obere oder untere Anfangsstellung gebracht, je nachdem, ob der Auftrag der Emulsion von oben nach unten oder von unten nach oben erfolgen soll. Die Rakeln befinden sich in ihrer äusseren horizontalen Ruhelage. Die Fotoemulsion wird in die Rakeln eingefüllt. Durch Betätigung des Schalters 65 wird die Zeitsteuerung für den Zylinderablauf in Gang gesetzt. Der Kolben 41 des oberen Zylinders 35 wird eingefahren, die Rakeln werden in horizontaler Lage nach innen gegen das Gewebe verschoben, bis sie dasselbe berühren. Eine Rakelkante 58 liegt dabei etwa 8 mm oberhalb der andern Kante 57. Durch Betätigung der Zylinder 36 und 37 werden die Kolben 52 und 59 ausgefahren, wodurch die Rakeln um die Drehachsen 55 und 56 nach oben gekippt werden. Die Fotoemulsion gelangt zum Gewebe 13. Das Drehzahlregelgerät 68 wird mit dem Schalter 67 eingeschaltet und die gewünschte Vorlaufgeschwindigkeit am Potentiometer 69 eingestellt. Der Motor 27 treibt über die Welle 28 die Zahnriemen 29 und 30 aus Gummi, welche die Wagen 15 und 16 von oben nach unten resp. von unten nach oben mit gleichmässiger Geschwindigkeit verschieben. Die Emulsion 34 wird auf das Gewebe 13 auf beiden Seiten aufgetragen. Die Auftragsgeschwindigkeit muss der gewünschten Dicke des aufgetragenen Belages der Fotoemulsion sowie deren Viskosität entsprechend eingestellt werden. Nachdem der Beschichtungsvorgang beendet ist, werden die Rakeln wiederum via Steuerung 66 nach unten geklappt und horizontal nach aussen verschoben. Durch Betätigung des Schalters 72 können die Führungswagen 15, 16 mit hoher Geschwindigkeit in die Ausgangslage verschoben werden, damit der Rahmen 14 mit dem Sieb 13 sofort nach dem Beschichtungsvorgang der Vorrichtung entnommen werden kann.

Im allgemeinen ist die Geschwindigkeit der beiden Rakeln bei einer Beschichtung von oben nach unten kleiner als bei einer Beschichtung von unten nach oben. Bei der Beschichtung von unten nach oben wird die Fotoemulsion von den Rakeln auch wieder bis zu einer gewissen Dicke abgestreift. Beim Beschichten von oben nach unten läuft ein Teil der Emulsion wieder vom Sieb 13 in die Rakeln 19, 20 zurück. Für den Auftrag von dicken Schichten ist eine Beschichtungsrichtung von oben nach unten von Vorteil.

Es hat sich gezeigt, dass bei einer Versetzung der beiden Rakeln gegeneinander in der Höhe um etwa 8 mm an die Kanten der Rakeln nicht allzu hohe Anforderungen gestellt werden müssen. Wenn die Rakeln in der Höhe gegeneinander verschoben sind, so drücken die Kanten 57 und 58 der Rakeln nicht auf gleicher Höhe gegeneinander. Die beiden Rakelkanten drücken das Gewebe 13 in entgegengesetzte Richtungen, so dass der Verlauf des Gewebes im Bereich der Rakelkanten 57 und 58 nicht eben ist. Dies hat zur Folge, dass das Gewebe auch dort an den Rakelkanten anliegt, wo dieselben von der Geradlinigkeit etwas abweichen. Dadurch kann vermieden werden, dass an den Stellen, wo die Rakelkanten von der Geradlinigkeit abweichen, Fotoemulsion in Streifen dem Gewebe 13 entlang nach unten läuft und eine ungleichmässigkeit des aufgetragenen Belages bewirkt. Das Versetzen der Rakeln in vertikaler Richtung hat ebenfalls den Vorteil, dass ein ruckfreier Lauf derselben erzielt werden kann. Für die Gleichmässigkeit der aufgetragenen Fotoemulsionsschicht ist ebenfalls ein erschütterungsfreier Lauf der Wagen 15, 16 resp. der Rakeln 19, 20 sehr wichtig. Dies wird vor allem durch Ausbildung der Antriebsorgane als Zahnriemen 29 und 30 aus Gummi sowie durch das Gegengewicht 25 erzielt.

Damit die Ränder der Wandungen 33 der Rakeln beim Auftrag der Schicht nicht gegeneinanderdrücken, kann eine Rakel etwas kürzer als die andere ausgebildet werden.

Bei früheren Beschichtungsverfahren von ebenen Druckschablonen von Hand konnte ein gleichmassiger reproduzierbarer dicker Auftrag kaum erzielt werden. Dickere Schichten haben den Vorteil, dass ein sogenannter "Kanaleffekt" auftritt. Beim Bedrucken, z. B. von Stoffen, kann die Farbe bei einem Teil des Musters, auf den viele Kreuzpunkte des Gewebes des Drucksiebes fallen, auch unter dieselben gelangen. Mit dem beschriebenen Verfahren kann eine sehr hohe Reproduzierbarkeit der Schicht in der Grössenordnung von etwa +1 μm erzielt werden.

Eine dicke Beschichtung des Drucksiebes 13 ist auch bei der Herstellung von gedruckten Schaltungen in der Elektronik von Vorteil, wenn dicke Leiter (höhere Ströme) erforderlich sind. Die Verwendung der beschichteten und belichteten Drucksiebe zur Herstellung gedruckter Schaltungen stellt ein wichtiges Anwendungsgebiet dar.

Die Rakeln 19, 20 bestehen vorzugsweise aus Aluminium, Chromstahl oder Kunststoff. Die Rakeln können vorne mit Lippen aus Gummi oder einem sonstigen elastischen Material versehen sein. Weiterhin können die Rakeln vorne ein rundes Profil für einen dicken Auftrag oder scharfkantig für einen dünnen Auftrag ausgebildet sein. Bei kleinen Drucksieben können mehrere Rakeln nebeneinander zum gleichzeitigen Beschichten mehrerer Drucksiebe angeordnet sein.

Anstelle der Rakeln 19, 20 könnte auch der Rahmen 14 mit dem Gewebe 13 vertikal von oben nach unten resp. von unten nach oben bewegt werden, wobei die Rakeln in der vertikalen Stellung fest bleiben würden, und nur die horizontale Bewegung sowie die Verkippung ausgeführt werden müsste.

Bei der Verwendung der Drucksiebe zur Einfärbung von Textilien erfolgt vorzugsweise ein dünner, einmaliger Auftrag der Fotoemulsion von unten nach oben. Bei sehr feinen Mustern wird eher ein dicker Auftrag gewählt.

Im weiteren finden die beschichteten Drucksiebe Anwendung für Reliefdruck in der Keramikindustrie, wobei dort ein dicker Auftrag gewählt wird und die Beschichtung vorzugsweise von oben nach unten erfolgt.

## Patentanspruch

Vorrichtung zum zweiseitigen Beschichten eines ebenen Drucksiebes mit einer Fotoemulsion, gekennzeichnet durch eine Halterung (7, 8, 11, 12) für das vertikal zu haltende Drucksieb (13), zwei horizontal angeordnete Beschichtungsrakeln (19, 20), Verstellorgane (31, 32) zur Steuerung der Rakelstellung, Antriebsmittel (27, 28, 29, 30) zur Ausführung einer vertikalen Bewegung der Rakeln oder des Drucksiebes zum Auftragen des in die Rakeln einfüllbaren Materials sowie eine Steuervorrichtung (26) zum Steuern der vertikalen Bewegung und der Rakelstellung bezüglich des Drucksiebes, wobei die Rakeln in der Höhe gegeneinander verschoben sind, so dass die vorderen Kanten (57, 58) der Rakeln (19, 20) in Arbeitsstellung nicht gegeneinander drücken, wobei die Rakeln (19, 20) mit auf vertikalen Pfosten (3, 4) geführten Wagen (15, 16) verbunden sind und die Antriebsmittel einen Motor (27), eine Welle (28) sowie Zahnriemen (29, 30) umfassen und an den Wagen (15, 16) die Verstellorgane (31, 32) zur Steuerung der Rakelstellung angebracht sind, die einen vertikalen oberen Zylinder (35), einen vertikalen Schlitten (44), mit dem Kolben (41) des vertikalen Zylinders (35) verbundene Hebel (45, 46), horizontale Schlitten (47, 48) zur horizontalen Bewegung der an Querstangen (17, 18) befestigten Rakeln und untere Zylinder (36, 37) zur Verkippung der Rakeln (19, 20) umfassen, wobei die Kolben (52, 59) der unteren Zylinder (36, 37) mit um Bolzen (55, 56) drehbaren Kipparmen (53, 54) verbunden sind.

## Revendication

Dispositif pour le revêtement d'un écran d'impression sur les deux côtés, avec une émulsion photographique, caractérisé par un support de maintien (7, 8, 11, 12) pour le maintien vertical de l'écran d'impression (13), par deux râcloirs d'enduction (19, 20) disposés horizontalement, par des organes d'ajustement (31, 32) pour commander la position des râcloirs, par des moyens d'entraînement (27, 28, 29, 30) pour l'exécution d'un mouvement vertical des râcloirs ou de l'écran d'impression, pour appliquer le matériau dont les racloirs peuvent être remplis, de même que par un dispositif de commande (26) pour commander le mouvement vertical et la position des râcloirs par rapport à l'écran d'impression, les râcloirs étant décalés en hauteur l'un par rapport à l'autre de façon que les arêtes avant (57, 58) des râcloirs (19, 20) ne se pressent pas l'une contre l'autre en position de travail, les râcloirs (19, 20) étant liés à des chariots (15, 16) guidés sur des montants verticaux (3, 4), les moyens d'entraînement comprenant un moteur (27), un arbre (28), de même que des courroies crantées (29, 30), et que les organes d'ajustement (31, 32) sont attenants aux chariots (15, 16) pour commander la position des râchoirs, ces organes d'ajustement comprenant un cylindre vertical supérieur (35), un coulisseau vertical (44), des leviers (45, 46) liés avec le piston (41) du cylindre vertical (35), des coulisseaux horizontaux (47, 48) pour le mouvement horizontal des râcloirs fixés à des barres transversales (17, 18), et des cylindres inférieurs (36, 37) pour le basculement des râcloirs (19, 20), les pistons (52, 59) des cylindres inférieurs (36, 37) étant reliés à des bras basculants (53, 54) pivotant autour de pivots (55, 56).

## Claim

Device for coating a flat printing screen on both sides with a photosensitive emulsion, characterized by a holding support (7, 8, 11, 12) for the printing screen (13) to be held vertically, two horizontally disposed coating squeegees (19, 20), adjustment members (31, 32) for controlling the squeegee position, drive means (27, 28, 29, 30) for carrying out a vertical movement of the squeegees or of the printing screen for applying the material with which the squeegees can be filled, as well as a control device (26) for controlling the vertical movement and the squeegee position with respect to the printing screen, the squeegees being mutually offset in height so that the front edges (57, 58) of the squeegees (19, 20) do not press against each other in operating position, the squeegees (19, 20) being connected to carriages (15, 16) guided on vertical posts (3, 4), and the drive means comprising a motor (27), a shaft (28), and sprocket belts (29, 30), and the adjustment members (31, 32) for controlling the squeegee position being mounted on the carriages (15, 16), which adjustment members comprise a vertical upper cylinder (35), a vertical slide (44), levers (45, 46) connected to the piston (41) of the vertical cylinder (35), horizontal slides (47, 48) for the horizontal movement of the squeegees secured to crossbars (17, 18), and lower cylinders (36, 37) for tilting the squeegees (19, 20), the pistons (52, 59) of the lower cylinders (36, 37) being connected to tilting arms (53, 54) pivotable about pins (55, 56).

# Fig.1

Fig.2

Fig.3

Fig.4

Fig. 5